(19) **Europäisches Patentamt European Patent Office Office européen des brevets**

(11) **EP 4 534 709 A1**

(12) **EUROPEAN PATENT APPLICATION**
published in accordance with Art. 153(4) EPC

(43) Date of publication:
**09.04.2025  Bulletin 2025/15**

(21) Application number: **23900220.7**

(22) Date of filing: **30.06.2023**

(51) International Patent Classification (IPC):
*C22C 21/02* (2006.01)     *C22F 1/00* (2006.01)
*C22F 1/043* (2006.01)     *H01L 21/60* (2006.01)

(52) Cooperative Patent Classification (CPC):
**C22C 21/02; C22F 1/00; C22F 1/043; H01L 21/60**

(86) International application number:
**PCT/JP2023/024324**

(87) International publication number:
**WO 2024/122089 (13.06.2024 Gazette 2024/24)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:  **05.12.2022  JP 2022194009**

(71) Applicants:
• **NIPPON STEEL CHEMICAL & MATERIAL CO.,
LTD.
Tokyo 103-0027 (JP)**
• **Nippon Micrometal Corporation
Iruma-shi
Saitama 358-0032 (JP)**

(72) Inventors:
• **OYAMADA, Tetsuya
Tokyo 100-8071 (JP)**
• **UNO, Tomohiro
Tokyo 100-8071 (JP)**
• **ODA, Daizo
Iruma-shi, Saitama 358-0032 (JP)**
• **ETO, Motoki
Iruma-shi, Saitama 358-0032 (JP)**
• **SUTO, Yuya
Iruma-shi, Saitama 358-0032 (JP)**

(74) Representative: **Grünecker Patent- und
Rechtsanwälte
PartG mbB
Leopoldstraße 4
80802 München (DE)**

(54) **AL ALLOY BONDING WIRE**

(57)    To provide an Al bonding wire satisfying excellent temperature cycle reliability and a favorable 1st bondability. The Al bonding wire contains 3.0% by mass or more and 10.0% by mass or less of Si, and an average diameter of a Si phase in a cross section (L cross-section) in a center axis direction including a wire center axis of the Al alloy bonding wire is equal to or larger than 0.8 um and equal to or smaller than 5.5 $\mu$m.

EP 4 534 709 A1

**Description**

**TECHNICAL FIELD**

The present invention relates to an Al alloy bonding wire. The present invention further relates to a semiconductor device including the Al alloy bonding wire. Background

In a semiconductor device, electrodes formed on a semiconductor chip are connected with a lead frame or electrodes on a substrate via a bonding wire. In a power semiconductor device, used is a bonding wire made mainly of aluminum (Al) as a material, and a wire diameter thereof mainly falls within a range from $\Phi300\ \mu m$ to $\Phi600\ \mu m$. In the power semiconductor device, silicon (Si) is often used as a material of the semiconductor chip, and an Al-Si alloy or an Al-Cu alloy is often used as a material of the electrode formed on the semiconductor chip. Power semiconductor devices using the Al bonding wire are often used as large power equipment such as air conditioners and photovoltaic power generation systems, or as vehicle-mounted semiconductor devices.

A bonding method for the Al bonding wire includes 1st bonding with the electrode on the semiconductor chip and 2nd bonding with the lead frame or the electrode on the substrate, and wedge bonding is used for both of them. The wedge bonding is a method for applying ultrasonic waves and loads to the Al bonding wire via a jig made of metal, breaking surface oxide films of a bonding wire material and an electrode material to expose new surfaces, and performing solid phase diffusion bonding. When a bonding failure is caused such that the Al bonding wire peels off from the electrode at the time of performing bonding, a failure may be caused in a product or a manufacturing yield may be lowered, so that there is a demand for favorable bonding strength of each bonding part. If ultrasonic waves or loads are strongly applied to a 1st bonding part to obtain favorable bonding strength, the semiconductor chip may be damaged. Thus, in the 1st bonding, it is required to suppress damage to the semiconductor chip in addition to obtaining the favorable bonding strength.

A next-generation power semiconductor device is required to stably operate for a long time as compared with a general-purpose power semiconductor device. The power semiconductor device operates while repeatedly turning on and off a current. When a current is supplied to a semiconductor chip made of Si via the Al bonding wire, a temperature of the 1st bonding part rises. On the other hand, when supply of the current is stopped, the temperature of the 1st bonding part falls. In this way, the temperature of the 1st bonding part repeatedly rises and falls at the time when the power semiconductor operates. Accordingly, thermal stress, which is caused by a thermal expansion difference between the Al bonding wire and the semiconductor chip, is repeatedly applied to the 1st bonding part. In a case of using a material made only of high-purity Al as the Al bonding wire, the Al bonding wire is broken in a relatively short time due to thermal stress, so that it has been difficult to satisfy performance required for the next-generation power semiconductor device. Thus, in the next-generation power semiconductor, it is required to improve a lifetime of wire bond accompanying a temperature rise and a temperature fall of the 1st bonding part (hereinafter, also referred to as "temperature cycle reliability").

In response to the requirement for the temperature cycle reliability, there has been developed an Al bonding wire focused on improvement in mechanical strength. As a method for improving a mechanical characteristic of the Al bonding wire, there has been developed a method for adding a specific element to Al.

Patent Literature 1 discloses a bonding wire made of an Al alloy containing at least magnesium (Mg) and silicon (Si), in which a total content of Mg and Si is equal to or larger than 0.03% by mass and equal to or smaller than 0.3% by mass. This Patent Literature discloses that lowering of bonding strength of the 1st bonding part is delayed in a thermal cycle test in a temperature range from 70°C to 120°C due to a high-strengthening effect exhibited by solid-solution strengthening of Mg or Si, and an effect of suppressing crack development exhibited by precipitated magnesium silicide ($Mg_2Si$).

Patent Literature 2 discloses a bonding wire made of an alloy containing 0.01 to 0.2% by mass of iron (Fe), 1 to 20 mass ppm of silicon (Si), and Al having purity of 99.997% by mass or more as a balance, in which a solid solution amount of Fe is 0.01 to 0.06%, a precipitation amount of Fe is 7 times or less the Fe solid solution amount, and the bonding wire has a fine structure having an average crystal grain size of 6 to 12 $\mu m$. This Patent Literature discloses that it is possible to suppress lowering of bonding strength of a 1st bonding part in a thermal shock test within a temperature range from -50°C to 200°C by uniformly dispersing intermetallic compound particles of Fe and Al in Al to improve mechanical strength of a matrix, and further refining recrystallized grains.

Patent Literature 3 discloses a bonding wire made by melting an Al-Si alloy containing 0.1 to 5% by mass of silicon (Si), and Al and impurities as a balance, and jetting and rapidly cooling it to be formed in a thin line. This Patent Literature discloses that mechanical strength is improved by rapidly cooling the melted Al-Si alloy to finely and uniformly disperse Si.

## EP 4 534 709 A1

### RELATED ART REFERENCE

**Patent Literature**

Patent Literature 1: Japanese Patent Application Laid-open No. 2014-131010
Patent Literature 2: Japanese Patent Application Laid-open No. 2014-129578
Patent Literature 3: Japanese Patent Application Laid-open No. S59-057440

## SUMMARY OF INVENTION

### PROBLEM TO BE SOLVED BY THE INVENTION

An Al bonding wire used in the next-generation power semiconductor device is required to have high temperature cycle reliability of the 1st bonding part to withstand a long-time use, and exhibit a favorable bonding quality in the 1st bonding part.

The next-generation power semiconductor device is required to withstand a longer-time use as compared with a general-purpose power semiconductor device. As described above, the temperature of the 1st bonding part repeatedly rises and falls at the time when the power semiconductor device operates. As a result, the Al bonding wire has a coefficient of linear thermal expansion larger than that of the semiconductor chip, so that there has been a problem in that thermal stress is caused due to a difference between coefficients of linear thermal expansion thereof at the 1st bonding part, which finally causes fatigue breakdown of the Al bonding wire. A temperature cycle test is one of the tests for evaluating, in an accelerated manner, a lifetime of wire bond accompanying a temperature rise and a temperature fall of the 1st bonding part (temperature cycle reliability). The Al bonding wire used for the next-generation power semiconductor is required to have excellent temperature cycle reliability in the temperature cycle test. However, in a case of using the Al bonding wire having high strength disclosed in Patent Literatures 1 to 3, it has been confirmed that there is a problem in that a crack develops at a relatively high speed in an Al alloy electrode having lower strength than that of the Al bonding wire in a temperature cycle test assuming a use in the next-generation power semiconductor device, and favorable temperature cycle reliability is difficult to be stably obtained.

That is, there have been several reports on effectiveness for the temperature cycle reliability of the Al bonding wire that is highly strengthened by adding other elements to Al, but effects thereof have been insufficient.

The present invention aims at providing an Al bonding wire satisfying excellent temperature cycle reliability and a favorable 1st bondability.

### MEANS FOR SOLVING PROBLEM

As a result of earnest investigation as to the problem described above, the present inventors have found that the problem described above can be solved by an Al alloy bonding wire containing 3.0% by mass or more and 10.0% by mass or less of Si, in which an average diameter of a Si phase is 0.8 to 5.5 $\mu$m in a cross section (L cross-section) in a center axis direction including a wire center axis of the Al alloy bonding wire, and further investigated the problem based on such knowledge to complete the present invention.

That is, the present invention includes the following content.

[1] An Al alloy bonding wire containing 3.0% by mass or more and 10.0% by mass or less of Si, wherein an average diameter of a Si phase in a cross section in a wire center axis direction including a wire center axis of the Al alloy bonding wire (L cross-section) is equal to or larger than 0.8 $\mu$m and equal to or smaller than 5.5 $\mu$m.

[2] The Al alloy bonding wire according to [1], wherein an average value of a ratio (a/b) between a length (a) of the Si phase in the wire center axis direction in the L cross-section and a length (b) of the Si phase in a direction perpendicular to the wire center axis in the L cross-section is equal to or larger than 1.3 and equal to or smaller than 3.2.

[3] The Al alloy bonding wire according to [1] or [2], wherein an average diameter of an $\alpha$ phase in the L cross-section is equal to or larger than 5 $\mu$m and equal to or smaller than 50 $\mu$m.

[4] The Al alloy bonding wire according to any one of [1] to [3], wherein, as a result of measuring a crystal orientation of the Si phase in the L cross-section, among crystal orientations in the wire center axis direction, an orientation ratio of a crystal orientation <110> angled at 15° or less to the wire center axis direction is equal to or higher than 30% and equal to or lower than 80%.

[5] The Al alloy bonding wire according to any one of [1] to [4], further containing 3 mass ppm or more and 150 mass ppm or less of one or more of Ni, Pd, and Pt in total.

3

[6] The Al alloy bonding wire according to any one of [1] to [5], wherein a balance of the Al alloy bonding wire comprises Al and inevitable impurities.

[7] A semiconductor device comprising the Al alloy bonding wire according to any one of [1] to [6].

**EFFECT OF THE INVENTION**

The present invention can provide an Al alloy bonding wire satisfying excellent temperature cycle reliability and a favorable 1st bondability.

**BRIEF DESCRIPTION OF DRAWINGS**

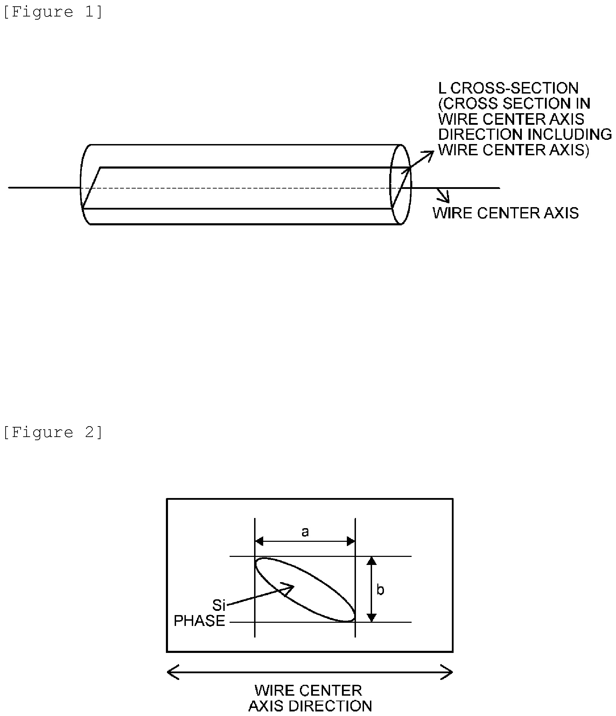

FIG. 1 is a schematic diagram for explaining a measurement target surface (inspection surface) at the time of measuring an average diameter and a crystal orientation of a Si phase for an Al alloy bonding wire. The measurement target surface is a cross section (L cross-section) in a center axis direction including a wire center axis of the Al alloy bonding wire.

FIG. 2 is a schematic diagram for explaining a length (a) of the Si phase in a wire center axis direction in the L cross-section, and a length (b) of the Si phase in a direction perpendicular to the wire center axis in the L cross-section.

**EMBODIMENT FOR CARRYING OUT THE INVENTION**

Hereinafter, the present invention will be described in detail with reference to preferable embodiments thereof. However, the present invention is not limited to the following embodiments and examples, and may be optionally changed to be implemented without departing from CLAIMS of the present invention and equivalents thereof.

[Al alloy bonding wire]

An Al alloy bonding wire according to the present invention (hereinafter, also simply referred to as a "wire according to the present invention" or a "wire") is an Al alloy bonding wire containing 3.0% by mass or more and 10.0% by mass or less of Si, in which an average diameter of a Si phase is equal to or larger than 0.8 $\mu$m and equal to or smaller than 5.5 $\mu$m in a cross section (L cross-section) in a center axis direction including a wire center axis of the wire. In the present invention, the wire center axis of the Al alloy bonding wire and the cross section (L cross-section) in the center axis direction including the wire center axis of the wire will be described later in "(Method for measuring average diameter of Si phase and shape of Si phase)" with reference to FIG. 1.

In a case of using a bonding wire composed only of high-purity Al in a temperature cycle test, a crack develops at a relatively high speed inside the bonding wire, and it has been difficult to obtain favorable temperature cycle reliability. On the other hand, in a case of using an Al bonding wire that is highly strengthened by adding elements thereto, a crack develops in an Al alloy electrode having relatively low strength, so that it has been confirmed that it is difficult to obtain temperature cycle reliability required for a next-generation power semiconductor device.

As a result of earnest investigation to solve the problem described above, the present inventors have found that the temperature cycle reliability can be improved by the Al alloy bonding wire containing 3.0% by mass or more and 10.0% by mass or less of Si, in which the average diameter of the Si phase in the L cross-section is equal to or larger than 0.8 $\mu$m and equal to or smaller than 5.5 $\mu$m. The wire according to the present invention significantly contributes to achieving temperature cycle reliability required for the next-generation power semiconductor device. The wire according to the present invention has a hypo-eutectic structure containing 3.0% by mass or more and 10.0% by mass or less of Si, and constituted of a Si phase and an $\alpha$ phase in which Si is dissolved in Al as a solid solution.

The reason why the wire according to the present invention can exhibit favorable temperature cycle reliability is estimated as follows. First, the coefficient of linear thermal expansion of the Si phase is smaller than that of Al, so that when the wire contains 3.0% by mass or more and 10.0% by mass or less of Si, it is possible to obtain an effect of reducing the coefficient of linear thermal expansion of the Al alloy bonding wire and reducing thermal stress generated during the temperature cycle test. Furthermore, by controlling the average diameter of the Si phase in the L cross-section of the Al alloy bonding wire to be equal to or larger than 0.8 $\mu$m, it is possible to suppress high-strengthening of the $\alpha$ phase due to precipitation-strengthening of the Si phase. Due to this, it is possible to obtain an effect of preventing a crack from developing in the Al alloy electrode during the temperature cycle test. Furthermore, by controlling the average diameter of the Si phase in the L cross-section of the Al alloy bonding wire to fall within a range equal to or larger than 0.8 $\mu$m and equal to or smaller than 5.5 $\mu$m, it is possible to sufficiently obtain an effect of suppressing further development of a crack when a distal end of the crack that has been developed during the temperature cycle test reaches a hard Si phase. As described above, it can be considered that the wire according to the present invention can exhibit favorable reliability by appropriately controlling a plurality of factors contributing to the improvement of the temperature cycle reliability.

In the temperature cycle test, from a viewpoint of obtaining favorable temperature cycle reliability, concentration of Si in the Al alloy bonding wire according to the present invention is equal to or larger than 3.0% by mass, preferably equal to or larger than 4.0% by mass, more preferably equal to or larger than 4.2% by mass, equal to or larger than 4.4% by mass, equal to or larger than 4.5% by mass, equal to or larger than 4.6% by mass, or equal to or larger than 4.8% by mass. On the other hand, if hardness of the Al alloy bonding wire becomes excessive, a semiconductor chip tends to be easily damaged at the time of 1st bonding under a bonding condition with ultrasonic waves and loads that are generally used. From a viewpoint of obtaining favorable bonding strength in a case of performing 1st bonding under a general bonding condition, Si concentration in the Al alloy bonding wire according to the present invention is equal to or smaller than 10% by mass, preferably equal to or smaller than 8.0% by mass or equal to or smaller than 7.0% by mass, and more preferably equal to or smaller than 6.8% by mass, equal to or smaller than 6.6% by mass, or equal to or smaller than 6.5% by mass.

From a viewpoint of obtaining favorable temperature cycle reliability in the temperature cycle test, the average diameter of the Si phase in the L cross-section of the wire according to the present invention is equal to or larger than 0.8 $\mu$m, preferably equal to or larger than 1.2 $\mu$m or equal to or larger than 1.4 $\mu$m, and more preferably equal to or larger than 1.5 $\mu$m, equal to or larger than 1.6 $\mu$m, or equal to or larger than 1.8 $\mu$m. On the other hand, if the Si phase becomes too coarse, number density of the Si phase is reduced, and it is difficult to stably obtain an effect of suppressing development of a crack by the Si phase. Thus, from a viewpoint of stably obtaining favorable temperature cycle reliability, the average diameter of the Si phase in the L cross-section of the wire according to the present invention is equal to or smaller than 5.5 $\mu$m, preferably equal to or smaller than 5.0 $\mu$m or equal to or smaller than 4.5 $\mu$m, and more preferably equal to or smaller than 4.0 $\mu$m.

For concentration analysis of elements contained in the wire according to the present invention, for example, an Inductively Coupled Plasma (ICP) emission spectrophotometer or an ICP mass spectrometer can be used. In a case in which elements derived from contaminants in the air, such as oxygen or carbon, are adsorbed by a surface of the wire, it is effective to clean it with acid or alkali depending on adsorbed substances before performing analysis.

The following describes a method for measuring the diameter of the Si phase in the L cross-section of the wire according to the present invention. As the method for measuring the diameter of the Si phase in the L cross-section, exemplified is a method of using a reflected electron image obtained by a Field Emission Scanning Electron Microscope (FE-SEM), for example. The following describes a specific measurement method. First, a reflected electron image of the L cross-section of the wire is acquired by using the FE-SEM. In the reflected electron image, the $\alpha$ phase and the Si phase are observed with different contrasts, and the Si phase is extracted by binarization processing using these contrasts. In the binarization processing, a luminance value of the acquired reflected electron image of the L cross-section is normalized to fall within a range from 0 to 1, and a threshold is determined in a range from 0.45 to 0.95 to perform binarization. At this point, the threshold is appropriately determined to be able to distinguish between the Si phase and the $\alpha$ phase. A scratch or a foreign substance, which adheres to the L cross-section at the time of preparing a sample, may be present on the L cross-section, and may be observed with a contrast close to the Si phase. To distinguish between such a foreign substance or scratch and the Si phase and exclude influence from the foreign substance or scratch, it is effective to specify the Si phase by measuring the Si concentration using an Energy Dispersive X-ray Spectrometer (EDS) mounted on the FE-SEM. In this way, after specifying the Si phase based on information of the Si concentration as needed, the Si phase is extracted by the binarization processing based on the reflected electron image. For each of the extracted Si phases, an equivalent circle diameter is calculated by using image analysis software (Esprit manufactured by Bruker Corporation, and the like). In the present invention, the equivalent circle diameter is assumed to be the diameter of the Si phase, and an arithmetic mean value of diameters of the Si phases is defined as an average diameter. Thus, in one embodiment, the average diameter of the Si phase in the L cross-section of the wire according to the present invention is calculated through procedures from (1) to (3) as follows.

(1) The reflected electron image of the L cross-section of the wire is acquired by using the FE-SEM.
(2) The Si phase is extracted by the binarization processing using the contrast of the acquired reflected electron image.
(3) Equivalent circle diameters are obtained by performing image analysis for the respective extracted Si phases, and the equivalent circle diameters are arithmetically averaged to calculate the average diameter of the Si phase.

In the above procedure (2), as described above, a guideline for setting a threshold may be made, and the Si phase may be specified by measuring the Si concentration by using the EDS to distinguish between a foreign substance or scratch and the Si phase as needed.

In the present invention, in calculating the average diameter of the Si phase, only Si phases having a diameter equal to or larger than 0.5 $\mu$m are considered as targets. Due to this, it is possible to accurately determine whether a requirement is met, the requirement being related to the average diameter of the Si phase that is suitable for satisfying the temperature cycle reliability required for the next-generation power semiconductor device.

In the present invention, a measurement region of the average diameter of the Si phase is determined so that a length in the wire center axis direction is equal to or larger than 100 μm and smaller than 400 μm, and the entire wire is accommodated in a direction perpendicular to the wire center axis.

-Shape of Si phase-

As a method for evaluating a lifetime of wire bond accompanying a temperature rise and a temperature fall of the 1st bonding part of the power semiconductor device, a test in which a temperature rise and a temperature fall are repeated in a shorter time than the temperature cycle test (hereinafter, also referred to as a "rapid temperature cycle test") may be used. For the next-generation power semiconductor device, it is desirable to obtain a more excellent lifetime of wire bond as compared with a conventional power semiconductor device even in the rapid temperature cycle test (hereinafter, also referred to as "rapid temperature cycle reliability").

In a process of investigating the Al alloy bonding wire containing 3.0% by mass or more and 10.0% by mass or less of Si in which the average diameter of the Si phase in the L cross-section is equal to or larger than 0.8 μm and equal to or smaller than 5.5 μm, the present inventors have further found that the shape of the Si phase in the L cross-section affects the rapid temperature cycle reliability. Specifically, they have found that the rapid temperature cycle reliability can be improved when an average value of a ratio (a/b) between a length (a) of the Si phase in the wire center axis direction in the L cross-section and a length (b) of the Si phase in the direction perpendicular to the wire center axis in the L cross-section is equal to or larger than 1.3 and equal to or smaller than 3.2. Description will be further made with reference to FIG. 2. FIG. 2 is a diagram schematically illustrating the Si phase in the L cross-section of the wire so that the wire center axis direction corresponds to a horizontal direction (right and left direction) of FIG. 2, and the direction perpendicular to the wire center axis corresponds to a vertical direction (upper and lower direction) of FIG. 2. Regarding the Si phase in the L cross-section, the "length (a) in the wire center axis direction" described above means a maximum dimension of the Si phase in the wire center axis direction, which corresponds to a dimension indicated by a sign "a" in FIG. 2. Regarding the Si phase in the L cross-section, the "length (b) in the direction perpendicular to the wire center axis" described above means a maximum dimension of the Si phase in the direction perpendicular to the wire center axis, which corresponds to a dimension indicated by a sign "b" in FIG. 2. Hereinafter, the ratio (a/b) between the length (a) of the Si phase in the wire center axis direction in the L cross-section and the length (b) of the Si phase in the direction perpendicular to the wire center axis in the L cross-section is also simply referred to as a "ratio (a/b) of the Si phase in the L cross-section".

Regarding the wire according to the present invention, the reason why the rapid temperature cycle reliability is improved by controlling the average value of the ratio (a/b) of the Si phase in the L cross-section is estimated as follows. During the rapid temperature cycle test, a crack develops inside the Al alloy bonding wire to cause breakdown. Cracks tend to develop along the wire center axis direction or a direction close thereto, so that it is considered that reduction of thermal stress in the wire center axis direction is effective. That is, it is considered that, by controlling the shape of the Si phase so that the length of the Si phase in the wire center axis direction in the L cross-section becomes larger than the length of the Si phase in the direction perpendicular to the wire center axis in the L cross-section by a certain length or more, the coefficient of linear thermal expansion in the wire center axis direction can be reduced, and as a result, the thermal stress in the wire center axis direction applied to the Al alloy bonding wire can be reduced. Specifically, it is considered that, by further controlling the average value of the ratio (a/b) of the Si phase in the L cross-section to be equal to or larger than 1.3 and equal to or smaller than 3.2 in addition to the fact that the wire contains 3.0% by mass or more and 10.0% by mass or less of Si, and the average diameter of the Si phase in the L cross-section is equal to or larger than 0.8 μm and equal to or smaller than 5.5 μm, an effect of reducing the thermal stress that causes fatigue breakdown of the Al alloy bonding wire is synergistically enhanced. In the rapid temperature cycle test, an exposure time to a high temperature is shorter than the temperature cycle test, so that recovery and recrystallization are less likely to occur, and plastic strain as driving force for crack development tends to be accumulated. An amount of plastic strain introduced into the Al alloy wire during the rapid temperature cycle test is reduced as the thermal stress is reduced, so that it is estimated that shape control for the Si phase described above has contributed to the improvement of the rapid temperature cycle reliability. To achieve an effect of improving the rapid temperature cycle reliability, it is sufficient that the average value of the ratio (a/b) of the Si phase in the L cross-section falls within the preferred range described above, and ratios (a/b) of all of the Si phases do not necessarily fall within a range equal to or larger than 1.3 and equal to or smaller than 3.2. For example, the Si phase having the ratio (a/b) smaller than 1.3 may be included like the Si phase satisfying a < b or a = b, or the Si phase having the ratio (a/b) exceeding 3.2 may be included.

From a viewpoint of reducing the thermal stress in the wire center axis direction that is caused during the rapid temperature cycle test and improving the rapid temperature cycle reliability, the average value of the ratio (a/b) of the Si phase in the L cross-section of the wire according to the present invention is more preferably equal to or larger than 1.4. On the other hand, when the average value of the ratio (a/b) is excessive, an end part of the Si phase has an acute angle, and a crack tends to be generated along an interface between the end part of the Si phase and the α phase, so that the effect of improving the rapid temperature cycle reliability cannot be obtained. Thus, the average value of the ratio (a/b) of the Si phase in the L cross-section of the wire according to the present invention is preferably equal to or smaller than 3.2, and more preferably equal to or smaller than 2.8.

The following describes a method for measuring the length (a) of the Si phase in the wire center axis direction in the L cross-section and the length (b) of the Si phase in the direction perpendicular to the wire center axis in the L cross-section of the wire according to the present invention. First, as a method for measuring the diameter of the Si phase in the L cross-section of the wire, similarly to the method described above, the reflected electron image of the L cross-section is acquired by the FE-SEM, and the Si phase is extracted by the binarization processing using the contrast of the acquired reflected electron image. As described above regarding the method for measuring the diameter of the Si phase, the guideline for setting a threshold for the binarization processing may be made, and the Si phase may be specified by measuring the Si concentration by using the EDS to distinguish between a foreign substance or scratch and the Si phase as needed. Subsequently, for each of the extracted Si phases, the length (a) in the wire center axis direction and the length (b) in the direction perpendicular to the wire center axis are calculated by using image analysis software (Esprit manufactured by Bruker Corporation, and the like). The average value of the ratio (a/b) of the Si phase in the L cross-section is assumed to be an arithmetic mean value of values of the ratio (a/b) calculated for the respective Si phases. Thus, in one embodiment, the average value of the ratio (a/b) of the Si phase in the L cross-section of the wire according to the present invention is calculated through procedures from (1) to (3) as follows.

(1) The reflected electron image of the L cross-section of the wire is acquired by using the FE-SEM.
(2) The Si phase is extracted by the binarization processing using the contrast of the acquired reflected electron image.
(3) Image analysis is performed on the respective extracted Si phases, ratios (a/b) are obtained by measuring the length (a) in the wire center axis direction and the length (b) in the direction perpendicular to the wire center axis, and the ratios (a/b) are arithmetically averaged to calculate the average value of the ratio (a/b) of the Si phase.

In the present invention, in calculating the ratio (a/b) of the Si phase in the L cross-section, only Si phases having a diameter (equivalent circle diameter) equal to or larger than 0.5 μm are considered as targets. Due to this, it is possible to accurately determine whether a requirement is met, the requirement being related to the ratio (a/b) of the Si phase in the L cross-section that is suitable for improving the rapid temperature cycle reliability.

Also in measuring the length (a) of the Si phase in the wire center axis direction in the L cross-section and the length (b) of the Si phase in the direction perpendicular to the wire center axis in the L cross-section, the measurement region is determined so that the length in the wire center axis direction is equal to or larger than 100 μm and smaller than 400 μm, and the entire wire is accommodated in the direction perpendicular to the wire center axis.

-Average diameter of α phase-

In the wire according to the present invention, an average diameter of the α phase in the L cross-section is preferably equal to or larger than 5 μm and equal to or smaller than 50 μm.

The present inventors have found that variations in bonding strength in 2nd bonding can be reduced when the average diameter of the α phase in the L cross-section falls within a range equal to or larger than 5 μm and equal to or smaller than 50 μm. A reason for this is considered to be a synergistic effect of accelerating uniform deformation of the wire by containing predetermined concentration of Si and controlling the average diameter of the Si phase in the L cross-section to fall within a predetermined range, and reducing variations in mechanical strength in the direction perpendicular to the wire center axis by causing the average diameter of the α phase in the L cross-section to be equal to or larger than 5 μm and equal to or smaller than 50 μm.

From a viewpoint of further reducing variations in the bonding strength in the 2nd bonding to achieve stability of more favorable bonding strength, the average diameter of the α phase in the L cross-section of the wire according to the present invention is more preferably equal to or larger than 10 μm, and even more preferably equal to or larger than 12 μm, equal to or larger than 14 μm, or equal to or larger than 15 μm. An upper limit of the average diameter of the α phase in the L cross-section is more preferably equal to or smaller than 45 μm, and even more preferably equal to or smaller than 40 μm, equal to or smaller than 38 μm, equal to or smaller than 36 μm, or equal to or smaller than 35 μm.

The following describes a method for measuring the diameter of the α phase in the L cross-section of the wire according to the present invention. In measuring the diameter of the α phase in the L cross-section, a method of combining information of Al concentration obtained by the SEM-EDS and information of a crystal orientation obtained by Electron BackScattered Diffraction (EBSD) can be used. Specifically, the L cross-section of the wire is assumed to be an inspection surface, and measurement of concentration of Al and Si using the EDS and crystal orientation analysis using the EBSD are performed at the same time. Subsequently, for a region that is specified as the α phase based on a measurement result of the EDS, a crystal orientation can be analyzed by using analysis software attached to the device. If an orientation difference between measurement points is equal to or larger than 15°, it is determined to be a crystal grain boundary, and an equivalent circle diameter is calculated. An arithmetic mean value of equivalent circle diameters of respective α phases is defined as the average diameter of the $\alpha$ phase. In a process of obtaining the diameter of the $\alpha$ phase, calculation is performed excluding a part in which the crystal orientation cannot be measured, and a part in which the crystal orientation can be measured but reliability of orientation analysis is low. Thus, in one embodiment, the average diameter of the $\alpha$ phase in the L cross-section of the wire according to the present invention is calculated through procedures from (1) to (3) as follows.

(1) The L cross-section of the wire is assumed to be the inspection surface, and measurement of concentration of Al and Si using the EDS and crystal orientation analysis using the EBSD are performed at the same time.
(2) For the region that is specified as the $\alpha$ phase based on the measurement result of the EDS, the crystal orientation is analyzed, and if the orientation difference between measurement points is equal to or larger than 15°, it is determined to be the crystal grain boundary, and the equivalent circle diameter of each crystal grain is obtained.
(3) The average diameter of the $\alpha$ phase is calculated by arithmetically averaging equivalent circle diameters of respective crystal grains.

In the present invention, in calculating the average diameter of the $\alpha$ phase in the L cross-section, only $\alpha$ phases having a diameter (equivalent circle diameter) equal to or larger than 0.5 $\mu$m are considered as targets. Due to this, it is possible to accurately determine whether a requirement is met, the requirement being related to the average diameter of the $\alpha$ phase in the L cross-section that is suitable for improving stability of bonding strength in the 2nd bonding.
In measuring the average diameter of the $\alpha$ phase in the L cross-section, the measurement region is determined so that the length in the wire center axis direction is equal to or larger than 100 $\mu$m and smaller than 400 $\mu$m, and the entire wire is accommodated in the direction perpendicular to the wire center axis.

-Crystal orientation of Si phase-

In the wire according to the present invention, as a result of further measuring the crystal orientation for the Si phase in the L cross-section, among crystal orientations in the wire center axis direction, an orientation ratio of a crystal orientation <110> angled at 15° or less to the wire center axis direction is preferably equal to or higher than 30% and equal to or lower than 80%. Hereinafter, the orientation ratio of the crystal orientation <110> is also referred to as the "orientation ratio of the crystal orientation <110> of the Si phase in the L cross-section".
The present inventors have found that loop straightness is improved when the orientation ratio of the crystal orientation <110> of the Si phase in the L cross-section is equal to or higher than 30% and equal to or lower than 80%. A reason for this is considered to be a synergistic effect of accelerating uniform deformation of the wire by containing predetermined concentration of Si and controlling the average diameter of the Si phase in the L cross-section to fall within a predetermined range, and reducing variations in mechanical strength in the wire center axis direction by causing the orientation ratio of the crystal orientation <110> of the Si phase in the L cross-section to be equal to or higher than 30% and equal to or lower than 80%.
From a viewpoint of further improving loop straightness, the orientation ratio of the crystal orientation <110> of the Si phase in the L cross-section of the wire according to the present invention is more preferably equal to or higher than 35%, and even more preferably equal to or higher than 40%, equal to or higher than 45%, or equal to or higher than 50%. On the other hand, there is a tendency that an effect of improving the loop straightness cannot be obtained when the orientation ratio of the crystal orientation <110> of the Si phase in the L cross-section exceeds 80% although a reason for that is not clear. An upper limit of the orientation ratio of the crystal orientation <110> of the Si phase in the L cross-section is preferably equal to or lower than 80%, and more preferably equal to or lower than 78%, equal to or lower than 76%, or equal to or lower than 75%.
In measuring the orientation ratio of the crystal orientation <110> of the Si phase in the L cross-section of the wire according to the present invention, a method of combining information of concentration of Al and Si obtained by the SEM-EDS and information of crystal orientation obtained by the EBSD can be used. Specifically, the L cross-section of the wire is assumed to be an inspection surface, and measurement of concentration of Al and Si using the EDS and crystal orientation analysis using the EBSD are performed at the same time. Subsequently, for a region that is specified as the Si phase based on a measurement result of the EDS, the orientation ratio of the crystal orientation <110> of the Si phase can be calculated by using analysis software attached to the device. In calculating the orientation ratio, the orientation ratio of the crystal orientation <110> is assumed to be an area ratio of the crystal orientation <110> that is calculated assuming that an area of only the crystal orientation identified based on certain reliability is a population in a measurement area. In a process of obtaining the orientation ratio, calculation was performed excluding a part in which the crystal orientation cannot be measured, and a part in which the crystal orientation can be measured but reliability of orientation analysis is low. Thus, in one embodiment, the orientation ratio of the crystal orientation <110> of the Si phase in the L cross-section of the wire according to the present invention is calculated through procedures of (1) and (2) as follows.

(1) The L cross-section of the wire is assumed to be the inspection surface, and measurement of concentration of Al and Si using the EDS and crystal orientation analysis using the EBSD are performed at the same time.

(2) For the region that is specified as the Si phase based on the measurement result of the EDS, the crystal orientation is analyzed, and the orientation ratio of the crystal orientation <110> of the Si phase is calculated.

In the present invention, the orientation ratio of the crystal orientation <110> of the Si phase in the L cross-section is assumed to be an arithmetic mean value of respective values of orientation ratios obtained by measuring three or more parts. In selecting the measurement region, from a viewpoint of securing objectivity of measurement data, it is preferable to acquire a sample for measurement to be measured from the bonding wire as a measurement target at intervals of 1 m or more with respect to the wire center axis direction. In the present invention, the measurement region for the crystal orientation measured by the EBSD method is determined so that the length in the wire center axis direction is equal to or larger than 100 $\mu$m and smaller than 400 $\mu$m, and the entire wire is accommodated in the direction perpendicular to the wire center axis.

-Addition of Ni, Pd, and Pt-

The wire according to the present invention may further contain 3 mass ppm or more and 150 mass ppm or less of one or more of Ni, Pd, and Pt in total.

The present inventors have found that corrosion resistance in a high-temperature and high-humidity environment can be improved by further containing 3 mass ppm or more and 150 mass ppm or less of one or more of Ni, Pd, and Pt in total. Although a reason for this is not clear, it is considered that an effect of improving corrosion resistance in a high-temperature and high-humidity environment by containing predetermined concentration of Si is synergistically enhanced by containing 3 mass ppm or more and 150 mass ppm or less of one or more of Ni, Pd, and Pt in total.

From a viewpoint of improving the corrosion resistance in a high-temperature and high-humidity environment, total concentration of Ni, Pd, and Pt in the wire according to the present invention is preferably equal to or larger than 3 mass ppm, more preferably equal to or larger than 5 mass ppm, equal to or larger than 6 mass ppm, equal to or larger than 8 mass ppm, or equal to or larger than 10 mass ppm, and an upper limit thereof is preferably equal to or smaller than 150 mass ppm, and more preferably equal to or smaller than 145 mass ppm, or equal to or smaller than 140 mass ppm.

As an aluminum raw material for manufacturing the wire according to the present invention, it is preferable to use Al having a purity of 4N (Al: 99.99% by mass or more), and more preferable to use Al having a purity of 5N (Al: 99.999% by mass or more) in which an amount of impurities is smaller. In a range of not inhibiting the effect of the present invention, the balance of the wire according to the present invention may contain an element other than Al. Content of Al in the wire according to the present invention is not limited so long as the content does not inhibit the effect of the present invention, preferably equal to or larger than 90% by mass, more preferably equal to or larger than 92% by mass, equal to or larger than 92.5% by mass, or equal to or larger than 93% by mass, and even more preferably equal to or larger than 93.5% by mass, equal to or larger than 94% by mass, equal to or larger than 94.5% by mass, equal to or larger than 94.6% by mass, equal to or larger than 94.8% by mass, or equal to or larger than 95% by mass. According to one embodiment, the balance of the wire according to the present invention consists of Al and inevitable impurities. Thus, according to a preferred embodiment, the wire according to the present invention consists of Al, Si, and inevitable impurities. According to another preferred embodiment, the wire according to the present invention consists of Al, Si, one or more of Ni, Pd, and Pt, and inevitable impurities.

In a preferred embodiment, the wire according to the present invention does not have a coating that contains a metal other than Al as a main component on the outer periphery of the wire. Herein, the "coating that contains a metal other than Al as a main component" means the coating in which the content of the metal other than Al is 50% by mass or more.

The wire according to the present invention can exhibit favorable rapid temperature cycle reliability, favorable bonding strength at the 2nd bonding part, loop straightness, and high corrosion resistance in a high-temperature and high-humidity environment while satisfying favorable temperature cycle reliability and a favorable bonding quality at the 1st bonding part. Accordingly, the bonding wire according to the present invention can be preferably used as an Al alloy bonding wire for a semiconductor device, especially as an Al alloy bonding wire for a power semiconductor device.

A wire diameter of the wire according to the present invention is not particularly limited, and may be appropriately determined depending on specific purposes. The wire diameter may be preferably equal to or larger than 50 $\mu$m, equal to or larger than 60 $\mu$m, equal to or larger than 80 $\mu$m, equal to or larger than 100 $\mu$m, equal to or larger than 120 $\mu$m, equal to or larger than 140 $\mu$m, equal to or larger than 150 $\mu$m, or the like. An upper limit of the wire diameter is not particularly limited, and may be equal to or smaller than 600 $\mu$m, equal to or smaller than 550 $\mu$m, equal to or smaller than 500 $\mu$m, or the like, for example.

(Method for manufacturing Al alloy bonding wire)

The following describes an example of a method for manufacturing the Al alloy bonding wire according to the present invention. Al and alloy elements as raw materials preferably have a high purity. Al preferably has a purity of 99.99% by mass or more and includes inevitable impurities as a balance. Si, Ni, Pd, and Pt used as alloy elements preferably have a purity of 99.9% by mass or more and include inevitable impurities as a balance. An Al alloy used for the bonding wire can be manufactured by loading an Al raw material and alloy elements as raw materials into a crucible made of graphite or alumina that is processed to obtain an ingot having a cylindrical shape, and melting the raw materials by using an electric furnace or a high-frequency heating furnace. A diameter of the ingot having a cylindrical shape is preferably equal to or larger than Φ6 mm and smaller than Φ8 mm while considering processability in a subsequent processing step. An atmosphere in the furnace at the time of melting is preferably an inert atmosphere or a reducing atmosphere to prevent Al or other elements constituting the wire from being excessively oxidized. The highest end-point temperature of melted metal at the time of melting preferably falls within a range equal to or higher than 700°C and lower than 1050°C to prevent impurity elements from being mixed into the melted metal from the crucible while securing fluidity of the melted metal. As a method for cooling after the melting, water cooling, furnace cooling, air cooling, and the like can be used.

By performing homogenization processing on the ingot having a cylindrical shape obtained by melting, and repeatedly performing wire-drawing processing using dies and intermediate heat treatment thereon, the wire having a desired wire diameter can be manufactured. The wire after being subjected to the wire-drawing processing can be used as the Al alloy bonding wire by performing final heat treatment using the electric furnace.

To control the average diameter of the Si phase in the L cross-section to fall within a range equal to or larger than 0.8 $\mu$m and equal to or smaller than 5.5 $\mu$m, it is effective to control manufacturing conditions such as a homogenization processing condition, a wire-drawing processing condition, an intermediate heat treatment condition, and a final heat treatment condition. At the time of wire-drawing processing, it is effective to use a lubricating liquid to secure lubricity at a contact interface between the wire and the die. The following describes an example of the manufacturing condition for controlling the average diameter of the Si phase in the L cross-section to fall within a range equal to or larger than 0.8 $\mu$m and equal to or smaller than 5.5 $\mu$m.

It is effective that a temperature range for the homogenization processing is set to be equal to or higher than 500°C and lower than 560°C, and a time therefor is set to be equal to or longer than 3 hours and shorter than 5 hours. Through this homogenization processing, it is possible to reduce variations in concentration of Si contained in the $\alpha$ phase crystallized out in a solidification process, and control deformation behavior of the Si phase due to the wire-drawing processing thereafter by growing the fine Si phase and softening the wire. Thereafter, by repeating the wire-drawing processing and the intermediate heat treatment, the diameter of the Si phase can be controlled. When the wire-drawing processing is performed, the Si phase is deformed in the wire center axis direction, and part of the Si phase is broken and becomes finer. On the other hand, when the intermediate heat treatment is performed, the Si phase is grown. Thus, to control the Si phase to have a desired diameter, it is important to optimize a condition for the wire-drawing processing, a temperature and a time for the intermediate heat treatment, the number of times of the intermediate heat treatment, and the wire diameter. Regarding the wire-drawing processing condition, it is effective to cause an area reduction ratio of the wire per die used at the time of wire-drawing processing to fall within a range equal to or larger than 10.5% and smaller than 12.5%. Herein, assuming that the area reduction ratio of the wire per die is P1, P1 is represented by the following expression.

$$P1 = \{(R_2{}^2 - R_1{}^2)/R_2{}^2\} \times 100$$

In the expression, $R_2$ represents a diameter (mm) of the wire before processing, and $R_1$ represents a diameter (mm) of the wire after processing.

Due to this, the Si phase can be substantially uniformly deformed in the entire wire. It is effective that a temperature range for the intermediate heat treatment is set to be equal to or higher than 400°C and lower than 440°C, and the time for the intermediate heat treatment is set to be equal to or longer than 1 hour and shorter than 2 hours. It is also effective that the number of times of the intermediate heat treatment is set to be two, a wire diameter for performing the first intermediate heat treatment is 2.6 to 3.0 times a final wire diameter, and a wire diameter for performing the second intermediate heat treatment is 1.6 to 2.0 times the final wire diameter. It is effective that a temperature range for the final heat treatment is set to be equal to or higher than 250°C and lower than 360°C, and a time for the final heat treatment is set to be equal to or longer than 20 hours and shorter than 24 hours. In a case of performing the final heat treatment without performing the intermediate heat treatment, breaking elongation required for the Al alloy bonding wire and a desired diameter of the Si phase cannot be obtained at the same time. As described above, it is effective that a condition for the intermediate heat treatment focuses on control of the diameter of the Si phase, and a condition for the final heat treatment focuses on control of breaking elongation. That is, by performing the intermediate heat treatment under a predetermined condition to grow the Si phase in advance, it is possible to easily control the diameter of the Si phase to be a desired diameter after the final heat treatment. Due to this, while causing the wire to be recrystallized and securing breaking elongation required for the Al alloy bonding wire, it is possible to easily control the Si phase to be grown to have a desired diameter.

The intermediate heat treatment and the final heat treatment can be performed by a method of heating for a certain time in the electric furnace. An atmosphere in the heat treatment is preferably an inert atmosphere or a reducing atmosphere to suppress excessive oxidation of Al and Si.

To control the average value of the ratio (a/b) of the Si phase in the L cross-section of the wire to fall within a range equal to or larger than 1.3 and equal to or smaller than 3.2, it is effective to control a wire feeding speed at the time of wire-drawing processing in accordance with the wire diameter for performing the wire-drawing processing. The following describes a preferred example of a condition of the wire feeding speed to control the average value of the ratio (a/b) to fall within a desired range.

A wire-drawing processing step from when the ingot is obtained by melting until the first intermediate heat treatment is performed is assumed to be "wire-drawing processing 1". A wire-drawing processing step from the first intermediate heat treatment to the second intermediate heat treatment is assumed to be "wire-drawing processing 2". A wire-drawing processing step from the second intermediate heat treatment until when the final diameter is obtained is assumed to be "wire-drawing processing 3". It is effective that the wire feeding speed in the wire-drawing processing 1 is equal to or higher than 15 m/minute and lower than 25 m/minute, the wire feeding speed in the wire-drawing processing 2 is equal to or higher than 30 m/minute and lower than 55 m/minute, and the wire feeding speed in the wire-drawing processing 3 is equal to or higher than 70 m/minute and lower than 90 m/minute. It is considered that this is because stress applied in the wire center axis direction can be controlled at the time of the wire-drawing processing by setting the wire feeding speed to fall within a predetermined range, and the average value of the ratio (a/b) of the Si phase in the L cross-section of the wire can be controlled to fall within a desired range.

To control the average diameter of the $\alpha$ phase in the L cross-section of the wire to fall within a range equal to or larger than 5 $\mu$m and equal to or smaller than 50 $\mu$m, it is effective to perform additional heat treatment before the final heat treatment with the final wire diameter. The following describes a method of additional heat treatment for controlling the average diameter of the $\alpha$ phase in the L cross-section to fall within a range equal to or larger than 5 $\mu$m and equal to or smaller than 50 $\mu$m, and an example of conditions therefor. For the additional heat treatment, a method of continuously sweeping the wire into a heated tubular furnace can be used. It is effective that a temperature range for the additional heat treatment is set to be equal to or higher than 540°C and lower than 560°C, and a time for the additional heat treatment is set to be equal to or longer than 1.5 seconds and shorter than 3.0 seconds. An inert gas is preferably refluxed in the tubular furnace to suppress excessive oxidation of Al and Si during the heat treatment. It is considered that this is because, by performing the additional heat treatment before the final heat treatment under the condition described above with a higher temperature and shorter time than those of the final heat treatment, the diameter of the $\alpha$ phase can be controlled to fall within a desired range while suppressing growth of the Si phase and recrystallizing the $\alpha$ phase.

To control the orientation ratio of the crystal orientation <110> of the Si phase in the L cross-section of the wire to fall within a range equal to or higher than 30% and equal to or lower than 80%, it is effective to control a reduction angle of the die (hereinafter, also referred to as a "die angle"). It is effective to set the die angle to be equal to or larger than 14° and smaller than 18° to control the orientation ratio of the crystal orientation <110> of the Si phase in the L cross-section to fall within the range from 30 to 80%. It is considered that this is because the crystal orientation of the Si phase can be controlled to fall within a desired range when a contact area between the wire and the die varies when the wire enters the die, and compressive stress applied to a wire surface varies.

[Semiconductor device]

The semiconductor device can be manufactured by connecting the electrode on the semiconductor chip to the lead frame or an external electrode on the substrate by using the wire of the present invention.

In one embodiment, the semiconductor device of the present invention includes a circuit board, the semiconductor chip, and the bonding wire for bringing the circuit board and the semiconductor chip into conduction with each other, and is characterized in that the bonding wire is the wire of the present invention.

In the semiconductor device of the present invention, the circuit board and the semiconductor chip are not particularly limited, and a known circuit board and semiconductor chip that may be used for constituting the semiconductor device may be used. Alternatively, a lead frame may be used in place of the circuit board. For example, like the semiconductor device disclosed in Japanese Patent Application Laid-open No. 2020-150116, the semiconductor device may include a lead frame and a semiconductor chip mounted on the lead frame.

Examples of the semiconductor device include various semiconductor devices used for electric products (for example, a computer, a cellular telephone, a digital camera, a television, an air conditioner, a solar power generation system), vehicles (for example, a motorcycle, an automobile, an electric train, a ship, and an aircraft), and the like, and a semiconductor device for electric power (power semiconductor device) is especially preferred.

[Examples]

Hereinafter, the present invention will be described in detail with reference to Examples. However, the present invention is not limited to the following Examples.

(Sample)

A method for producing a sample will be described. As a raw material, Al having a purity of 4N (99.99% by mass or more) and including inevitable impurities as a balance was used. Si, Ni, Pd, and Pt used as alloy elements each having a purity of 99.99% by mass or more and including inevitable impurities as a balance were also used. The Al alloy used for the bonding wire was manufactured by loading an Al raw material and the alloy elements as raw materials into an alumina crucible, and melting them by using a high-frequency heating furnace. An atmosphere inside the furnace at the time of melting was an Ar atmosphere, and the highest end-point temperature of melted metal at the time of melting was 800°C. A cooling method after the melting was furnace cooling.

After an ingot of Φ6 mm having a cylindrical shape was obtained by melting, and the ingot was subjected to homogenization processing, wire-drawing processing using dies and intermediate heat treatment were performed to produce a wire of Φ300 μm. A temperature range for the homogenization processing was set to be equal to or higher than 500°C and lower than 560°C, and a time therefor was set to be equal to or longer than 3 hours and shorter than 5 hours. A commercially available lubricating liquid was used at the time of the wire-drawing processing, and an area reduction ratio of the wire per die at the time of the wire-drawing processing was equal to or larger than 10.5% and smaller than 12.5%. A temperature range for the intermediate heat treatment was set to be equal to or higher than 400°C and lower than 440°C, and a time for the intermediate heat treatment was set to be equal to or longer than 1 hour and shorter than 2 hours. The number of times of the intermediate heat treatment was set to be two, a wire diameter for performing the first intermediate heat treatment was 2.6 to 3.0 times the final wire diameter, and a wire diameter for performing the second intermediate heat treatment was 1.6 to 2.0 times the final wire diameter. A temperature range for the final heat treatment was set to be equal to or higher than 250°C and lower than 360°C, and a time for the final heat treatment was set to be equal to or longer than 20 hours and shorter than 24 hours.

In some Examples, the wire feeding speed in the wire-drawing processing 1 was set to be equal to or higher than 15 m/minute and lower than 25 m/minute, the wire feeding speed in the wire-drawing processing 2 was set to be equal to or higher than 30 m/minute and lower than 55 m/minute, and the wire feeding speed in the wire-drawing processing 3 was set to be equal to or higher than 70 m/minute and lower than 90 m/minute. In some Examples, additional heat treatment was performed before the final heat treatment with the final wire diameter, and the condition for the additional heat treatment was set such that a temperature range was equal to or higher than 540°C and lower than 560°C, and a time was equal to or longer than 1.5 seconds and shorter than 3.0 seconds. In some Examples, the wire-drawing processing was performed by using dies having a die angle equal to or larger than 14° and smaller than 18°.

(Method for measuring element content)

For concentration analysis of elements contained in the bonding wire, ICP-OES ("PS3520UVDDII" manufactured by Hitachi High-Tech Science Corporation) or ICP-MS ("Agilent 7700x ICP-MS" manufactured by Agilent Technologies, Inc.) was used as an analysis device.

(Method for measuring average diameter of Si phase and shape of Si phase)

An inspection surface was the L cross-section of the Al alloy bonding wire, and the average diameter of the Si phase and the shape of the Si phase were measured. In the present invention, the wire center axis and the cross section (L cross-section) in the wire center axis direction including the wire center axis are illustrated in FIG. 1. The FE-SEM and the EDS were used for measurement, and the average diameter of the Si phase, the length (a) of the Si phase in the wire center axis direction and the length (b) of the Si phase in the direction perpendicular to the wire center axis were calculated through the procedure described above. The measurement region was determined so that the length in the wire center axis direction was 200 μm, and the entire wire was accommodated in the direction perpendicular to the wire center axis. At the time of processing the cross section to expose the L cross-section of the Al alloy bonding wire, the cross section may be deviated from the wire center axis. At this point, if the length in the direction perpendicular to the wire center axis of the L cross-section is 90% or more of the wire diameter, the L cross-section can be regarded as a cross section including the wire center axis. This is because, if the length in the perpendicular direction of the L cross-section is equal to or larger than 90%, an effect of deviation from the wire center axis on measurement result of the average diameter of the Si phase or the shape of the Si phase is negligibly small.

(Method for measuring orientation ratio of crystal orientation <110> of Si phase)

The L cross-section of the Al alloy bonding wire was an inspection surface, and among crystal orientations in the wire center axis direction of the Si phase, the orientation ratio of the crystal orientation <110> angled at 15° or less to the wire center axis direction was measured. In measuring the orientation ratio of the crystal orientation <110>, a method of combining information of Si concentration obtained by the SEM-EDS and information of the crystal orientation obtained by the EBSD was used. Specifically, measurement of the concentration of Al and Si using the EDS and crystal orientation analysis using the EBSD were performed at the same time. Subsequently, for the region that is specified as the Si phase based on a measurement result of the EDS, the orientation ratio of the crystal orientation <110> was calculated by using analysis software attached to the device. Measurement regions at three parts were randomly selected at intervals of 1 m or more with respect to the wire center axis direction, and an arithmetic mean value of orientation ratios of the crystal orientation <110> of the Si phase obtained from the measurement regions at the three parts was the orientation ratio of the crystal orientation <110> of the Si phase of a measurement sample. The measurement region was determined so that the length in the wire center axis direction was 200 $\mu$m, and the entire wire was accommodated in the direction perpendicular to the wire center axis.

(Method for measuring average diameter of $\alpha$ phase)

The L cross-section of the Al alloy bonding wire was an inspection surface, and measurement of the concentration of Al and Si using the EDS and crystal orientation analysis using the EBSD were performed at the same time. Subsequently, for the region that is identified as the $\alpha$ phase based on the measurement result of the EDS, if an orientation difference between measurement points was equal to or larger than 15°, it was determined to be a crystal grain boundary, and an equivalent circle diameter was calculated using analysis software attached to the device. An arithmetic mean value of equivalent circle diameters of the respective $\alpha$ phases was the average diameter of the $\alpha$ phase. The measurement region was determined so that the length in the wire center axis direction was 200 $\mu$m, and the entire wire was accommodated in the direction perpendicular to the wire center axis.

(Method for evaluating Al alloy bonding wire)

The following describes a method for evaluating the Al alloy bonding wire. The wire diameter of the Al alloy bonding wire used for evaluation was $\Phi$300 $\mu$m. The semiconductor chip made of Si was used, and as the electrode on the semiconductor chip, used was an alloy having a composition of Al-0.5%Cu deposited to have a thickness of 5 $\mu$m. As a substrate, 15 $\mu$m of Ni was deposited on an Al alloy. For bonding of the Al alloy bonding wire, a commercially available wire bonder (manufactured by Ultrasonic Engineering Co., Ltd.) was used.

(Method for evaluating temperature cycle reliability)

For evaluation in the temperature cycle test, a commercially available thermal shock test device was used. In the temperature cycle test, a temperature rise and a temperature fall are repeated when a sample chamber moves between a low-temperature tank and a high-temperature tank. A temperature of the low-temperature tank was -40°C, and a temperature of the high-temperature tank was 175°C. The test was started in a state in which the sample chamber was present in the high-temperature tank, and a period from when the sample chamber moved to the low-temperature tank until it returned to the high-temperature tank was one cycle. A time during which the sample chamber stayed in each of the low-temperature tank and the high-temperature tank was 20 minutes. A sample to be subjected to the temperature cycle test had a structure in which a semiconductor chip was mounted on a substrate, and an electrode on the semiconductor chip is connected with an electrode on the substrate via the Al alloy bonding wire. After the test was started, the sample was taken out every 100 cycles, and a shear test was performed on the 1st bonding part. As a value of shear force of the 1st bonding part used for evaluating the temperature cycle reliability, an arithmetic mean value of shear force of 1st bonding parts at five points, which were randomly extracted, was used. The number of cycles at the time when the shear force was lowered to 70% or less of a value before the temperature cycle test was a lifetime of wire bond. If the lifetime of wire bond was shorter than 500 cycles, it was determined that there was a problem in a practical use and the value was determined to be "0". If the lifetime of wire bond was equal to or longer than 500 cycles and shorter than 750 cycles, it was determined that there was no problem in a practical use and the value was determined to be "1". If the lifetime of wire bond was equal to or longer than 750 cycles and shorter than 1000 cycles, it was determined to be excellent and the value was determined to be "2". If the lifetime of wire bond was equal to or longer than 1000 cycles, it was determined to be especially excellent and the value was determined to be "3". "0" is unacceptable, and "1", "2", and "3" are acceptable. Evaluation results are described in a column of "Temperature cycle reliability" in tables.

(Method for evaluating rapid temperature cycle reliability)

For evaluation of the rapid temperature cycle test, a commercially available rapid-rate thermal shock test device was used. A sample to be subjected to the rapid temperature cycle test was the same as the sample used for evaluating the temperature cycle reliability. Heating and cooling were performed as one cycle to repeatedly apply a thermal load to the sample disposed in a sample chamber of the rapid-rate thermal shock test device. A minimum temperature was -50°C, and a maximum temperature was 175°C. A heating time including a temperature rising time was 20 seconds, and a cooling time including a temperature falling time was 40 seconds. After the test was started, the sample was taken out every 500 cycles, and a shear test was performed on the 1st bonding part. As a value of shear force of the 1st bonding part used for evaluating the temperature cycle reliability, an arithmetic mean value of shear force of 1st bonding parts at five points, which were randomly extracted, was used. The number of cycles at the time when the shear force was lowered to 70% or less of a value before the temperature cycle test was the lifetime of wire bond. If the lifetime of wire bond was shorter than 4000 cycles, it was determined that there was a problem in a practical use and the value was determined to be "0". If the lifetime of wire bond was equal to or longer than 4000 cycles and shorter than 6000 cycles, it was determined that there was no problem in a practical use and the value was determined to be "1". If the lifetime of wire bond was equal to or longer than 6000 cycles and shorter than 8000 cycles, it was determined to be excellent and the value was determined to be "2". If the lifetime of wire bond was equal to or longer than 8000 cycles, it was determined to be especially excellent and the value was determined to be "3". "0" is unacceptable, and "1", "2", and "3" are acceptable. Evaluation results are described in a column of "Rapid temperature cycle reliability" in tables.

(Method for evaluating 1st bondability)

The following describes a method for evaluating a 1st bondability. The 1st bondability was evaluated by a shear force test. The 1st bonding was performed at ten points under a general bonding condition, and the shear force of the 1st bonding part was measured. A commercially available micro shear force tester was used for measuring the shear force. A shear rate was 200 $\mu$m/sec, and a height of a shearing tool was 10 $\mu$m from an electrode surface. The shear force was measured by fixing, with a jig, the substrate to which the wire was bonded. Among the 1st bonding parts at the ten points, if there was at least one point where the shear force was smaller than 800 gf, it was determined to be unacceptable and evaluated as "0". If the shear force was equal to or larger than 800 gf and smaller than 1100 gf at all of the ten points, it was determined that there was no problem in a practical use and evaluated as "1". Furthermore, if there is no point where the shear force is smaller than 800 gf among the ten points, and a point where the shear force is equal to or larger than 1100 gf was included therein, it was determined to be excellent and evaluated as "2". In a case in which the electrode on the semiconductor chip was removed by alkali and the like after the shear force test, and a crack was found on the semiconductor chip when the semiconductor chip was observed by an optical microscope, it was determined that there was a problem in a practical use and evaluated as "0" even if the shear force of the 1st bonding part was equal to or larger than 800 gf. "0" is unacceptable, and "1" and "2" are acceptable. Evaluation results are described in a column of "1st bondability" in the tables.

(Method for evaluating bonding strength stability of 2nd bonding part)

The shear force test was performed on 2nd bonding parts at fifty points, which were randomly selected, to acquire the bonding strength, and a population standard deviation ($\sigma$) was calculated. If $\sigma$ was equal to or larger than 80 gf, it was determined that there was a problem in a practical use, and evaluated as "0". If $\sigma$ was equal to or larger than 40 gf and smaller than 80 gf, it was determined to be favorable and evaluated as "1". If $\sigma$ was smaller than 40 gf, it was determined to be excellent and evaluated as "2". "0" is unacceptable, and "1" and "2" are acceptable. Evaluation results are described in a column of "Bonding strength stability of 2nd bonding part" in the tables.

(Method for evaluating loop straightness)

The following describes a method for evaluating loop straightness. A condition for forming a loop was a loop length of 35.0 mm, and a loop height of 8 mm. When a distance between wire bonding parts was X, and a length of a line passing through the wire center axis was Y when the substrate was observed from right above with an optical microscope, regarding ten bonded bonding wires, if an arithmetic mean value of a value obtained by dividing Y by X (that is, Y/X) satisfied $1.04 \leq Y/X$, it was determined to be a fault and evaluated as "0". If $1.02 \leq Y/X < 1.04$ was satisfied, it was determined to be favorable and evaluated as "1". If $Y/X < 1.02$ was satisfied, it was determined to be excellent and evaluated as "2". "0" is unacceptable, and "1" and "2" are acceptable. Evaluation results are described in a column of "Loop straightness" in the tables.

(Method for evaluating corrosion resistance in high-temperature and high-humidity environment)

Ten Al alloy bonding wires were bonded under a general bonding condition, sealed with epoxy resin, and left in a high-temperature and high-humidity furnace. A test condition for a high-temperature and high-humidity test was a temperature of 130°C and relative humidity of 85%, and an atmosphere in the high-temperature and high-humidity furnace was air atmosphere. In the sample after the high-temperature and high-humidity test, a cross section of a wire loop portion in the wire center axis direction including the wire center axis was exposed by mechanical polishing, and it was examined whether corrosion was caused in the Al alloy bonding wire every 500 hours. The FE-SEM was used to check whether corrosion was caused. A visual field to be observed was 99% or more of the wire diameter, and the length in the wire center axis direction of 1 mm or more. A point where presence/absence of corrosion was checked was the entire visual field to be observed. After 2500 hours had elapsed, surfaces of the ten wires were observed with 200-fold magnification. If corrosion was found at a position at 15 $\mu$m from the wire surface toward the wire center axis, it was determined that there was a problem in a practical use, and evaluated as "0". If no corrosion was found at a position at 15 $\mu$m from the wire surface toward the wire center axis in all of the ten wires, it was determined that there was no problem in a practical use, and evaluated as "1". Furthermore, at the time when 3500 hours had elapsed, if no corrosion was found at a position at 15 $\mu$m from the wire surface toward the wire center axis in all of the ten wires, it was determined to be excellent, and evaluated as "2". In corrosion of the wire, even in a case in which the corrosion had progressed in a circumferential direction of the wire, it was determined that there was no problem in a practical use if no corrosion was found at a position at 15 $\mu$m or more from the wire surface toward the wire center axis. "0" is unacceptable, and "1" and "2" are acceptable. Evaluation results are described in a column of "Corrosion resistance in high-temperature and high-humidity environment" in the tables.
The evaluation results of Examples and Comparative Examples are indicated in Table 1 to Table 5.

[Table 1]

(Table 1)

| | No. | Si (% by mass) | Ni (mass ppm) | Pd (mass ppm) | Pt (mass ppm) | Ni+Pd+Pt (mass ppm) | Average diameter of Si phase*1 (μm) | Shape of Si phase*1 (a/b) | Average diameter of α phase*1 (μm) | Orientation ratio of crystal orientation <110>*2 (%) | Temperature cycle reliability | Rapid temperature cycle reliability | 1 st bondability | Bonding strength stability of 2nd bonding part | Loop straightness | Corrosion resistance in high-temperature and high-humidity environment |
|---|---|---|---|---|---|---|---|---|---|---|---|---|---|---|---|---|
| Example | 1 | 3.0 | | | | 0 | 0.8 | 1.2 | 3 | 9 | 1 | 1 | 2 | 1 | 1 | 1 |
| | 2 | 3.1 | | | | 0 | 1.5 | 1.3 | 3 | 11 | 2 | 2 | 2 | 1 | 1 | 1 |
| | 3 | 3.0 | | | | 0 | 4.0 | 3.2 | 3 | 8 | 2 | 2 | 2 | 1 | 1 | 1 |
| | 4 | 3.2 | | | | 0 | 5.5 | 3.3 | 4 | 13 | 1 | 1 | 2 | 1 | 1 | 1 |
| | 5 | 3.1 | | | | 0 | 0.9 | 1.3 | 3 | 11 | 1 | 2 | 2 | 1 | 1 | 1 |
| | 6 | 3.0 | | | | 0 | 1.5 | 1.4 | 3 | 8 | 2 | 3 | 2 | 1 | 1 | 1 |
| | 7 | 3.0 | | | | 0 | 4.0 | 2.8 | 4 | 22 | 2 | 3 | 2 | 1 | 1 | 1 |
| | 8 | 3.1 | | | | 0 | 5.5 | 2.9 | 4 | 18 | 1 | 2 | 2 | 1 | 1 | 1 |
| | 9 | 3.1 | | | | 0 | 0.8 | 1.2 | 5 | 15 | 1 | 1 | 2 | 2 | 1 | 1 |
| | 10 | 3.0 | | | | 0 | 1.5 | 1.3 | 16 | 24 | 2 | 2 | 2 | 2 | 1 | 1 |
| | 11 | 3.1 | | | | 0 | 4.0 | 3.2 | 30 | 22 | 2 | 2 | 2 | 2 | 1 | 1 |
| | 12 | 3.0 | | | | 0 | 5.5 | 3.3 | 50 | 29 | 1 | 1 | 2 | 2 | 1 | 1 |
| | 13 | 3.0 | | | | 0 | 0.8 | 1.4 | 35 | 30 | 1 | 3 | 2 | 2 | 2 | 1 |
| | 14 | 3.2 | | | | 0 | 1.5 | 1.6 | 23 | 56 | 2 | 3 | 2 | 2 | 2 | 1 |
| | 15 | 3.1 | | | | 0 | 4.0 | 2.8 | 22 | 80 | 2 | 3 | 2 | 2 | 2 | 1 |
| | 16 | 3.0 | | | | 0 | 5.5 | 3.1 | 35 | 81 | 1 | 2 | 2 | 2 | 1 | 1 |
| | 17 | 3.0 | 3 | | | 3 | 3.0 | 2.6 | 17 | 45 | 2 | 3 | 2 | 2 | 2 | 2 |
| | 18 | 3.0 | 148 | | | 148 | 2.2 | 2.3 | 16 | 43 | 2 | 3 | 2 | 2 | 2 | 2 |
| | 19 | 3.1 | | 3 | | 3 | 3.0 | 2.7 | 18 | 38 | 2 | 3 | 2 | 2 | 2 | 2 |
| | 20 | 3.0 | | 149 | | 149 | 2.3 | 2.5 | 16 | 35 | 2 | 3 | 2 | 2 | 2 | 2 |
| | 21 | 3.0 | | | 3 | 3 | 3.0 | 2.6 | 19 | 42 | 2 | 3 | 2 | 2 | 2 | 2 |

16

EP 4 534 709 A1

(continued)

| No. | Contained element and content concentration | | | | | Average diameter of Si phase*1 (μm) | Shape of Si phase*1 (a/b) | Average diameter of α phase*1 (μm) | Orientation ratio of crystal orientation <110>*2 (%) | Evaluation result | | | | | |
|---|---|---|---|---|---|---|---|---|---|---|---|---|---|---|---|
| | Si (% by mass) | Ni (mass ppm) | Pd (mass ppm) | Pt (mass ppm) | Ni+Pd+Pt (mass ppm) | | | | | Temperature cycle reliability | Rapid temperature cycle reliability | 1 st bondability | Bonding strength stability of 2nd bonding part | Loop straightness | Corrosion resistance in high-temperature and high-humidity environment |
| 22 | 3.0 | | | 147 | 147 | 2.1 | 1.9 | 15 | 40 | 2 | 3 | 2 | 2 | 2 | 2 |

*1 Inspection surface is L cross-section (cross section in wire center axis direction including wire center axis)

*2 As a result of measuring crystal orientation of Si phase in L cross-section, among crystal orientations in wire center axis direction, orientation ratio (%) of crystal orientation <110> angled at 15° or less to wire center axis direction

[Table 2]

[Table 2]

(Table 2)

|  | No. | Contained element and content concentration | | | | | Average diameter of Si phase*1 (μm) | Shape of Si phase*1 (a/b) | Average diameter of α phase*1 (μm) | Orientation ratio of crystal orientation <110>*2 (%) | Evaluation result | | | | | |
|  |  | Si (% by mass) | Ni (mass ppm) | Pd (mass ppm) | Pt (mass ppm) | Ni+Pd+Pt (mass ppm) |  |  |  |  | Temperature cycle reliability | Rapid temperature cycle reliability | 1st bondability | Bonding strength stability of 2nd bonding part | Loop straightness | Corrosion resistance in high-temperature and high-humidity environment |
|---|---|---|---|---|---|---|---|---|---|---|---|---|---|---|---|---|
| Example | 23 | 4.0 |  |  |  | 0 | 0.8 | 1.2 | 3 | 10 | 2 | 1 | 2 | 1 | 1 | 1 |
|  | 24 | 4.1 |  |  |  | 0 | 1.5 | 1.3 | 3 | 12 | 3 | 2 | 2 | 1 | 1 | 1 |
|  | 25 | 4.0 |  |  |  | 0 | 4.0 | 3.2 | 4 | 10 | 3 | 2 | 2 | 1 | 1 | 1 |
|  | 26 | 4.0 |  |  |  | 0 | 5.5 | 3.4 | 4 | 14 | 2 | 1 | 2 | 1 | 1 | 1 |
|  | 27 | 4.2 |  |  |  | 0 | 0.9 | 1.3 | 4 | 12 | 2 | 2 | 2 | 1 | 1 | 1 |
|  | 28 | 4.0 |  |  |  | 0 | 1.5 | 1.5 | 3 | 8 | 3 | 3 | 2 | 1 | 1 | 1 |
|  | 29 | 4.1 |  |  |  | 0 | 4.0 | 2.8 | 4 | 25 | 3 | 3 | 2 | 1 | 1 | 1 |
|  | 30 | 4.0 |  |  |  | 0 | 5.5 | 3.0 | 4 | 17 | 2 | 2 | 2 | 1 | 1 | 1 |
|  | 31 | 4.0 |  |  |  | 0 | 0.8 | 1.2 | 5 | 15 | 2 | 1 | 2 | 2 | 1 | 1 |
|  | 32 | 4.1 |  |  |  | 0 | 1.6 | 1.5 | 18 | 23 | 3 | 3 | 2 | 2 | 1 | 1 |
|  | 33 | 4.0 |  |  |  | 0 | 3.9 | 2.8 | 28 | 24 | 3 | 3 | 2 | 2 | 1 | 1 |
|  | 34 | 4.0 |  |  |  | 0 | 5.5 | 3.2 | 50 | 29 | 2 | 2 | 2 | 2 | 1 | 1 |
|  | 35 | 4.0 |  |  |  | 0 | 0.8 | 1.3 | 11 | 30 | 2 | 2 | 2 | 2 | 2 | 1 |
|  | 36 | 4.1 |  |  |  | 0 | 1.5 | 1.4 | 25 | 54 | 3 | 3 | 2 | 2 | 2 | 1 |
|  | 37 | 4.0 |  |  |  | 0 | 4.0 | 2.8 | 23 | 67 | 3 | 3 | 2 | 2 | 2 | 1 |
|  | 38 | 4.0 |  |  |  | 0 | 5.4 | 3.0 | 45 | 77 | 2 | 2 | 2 | 2 | 2 | 1 |
|  | 39 | 5.0 |  |  |  | 0 | 0.8 | 1.2 | 8 | 30 | 2 | 1 | 2 | 2 | 2 | 1 |
|  | 40 | 5.0 |  |  |  | 0 | 1.6 | 1.4 | 20 | 54 | 3 | 3 | 2 | 2 | 2 | 1 |
|  | 41 | 5.1 |  |  |  | 0 | 3.8 | 2.7 | 21 | 65 | 3 | 3 | 2 | 2 | 2 | 1 |
|  | 42 | 5.0 |  |  |  | 0 | 5.4 | 3.2 | 34 | 74 | 2 | 2 | 2 | 2 | 2 | 1 |
|  | 43 | 5.2 | 3 |  |  | 3 | 5.5 | 3.3 | 34 | 73 | 2 | 1 | 2 | 2 | 2 | 2 |

(continued)

| No. | Contained element and content concentration | | | | | Average diameter of Si phase*1 ($\mu$m) | Shape of Si phase*1 (a/b) | Average diameter of $\alpha$ phase*1 ($\mu$m) | Orientation ratio of crystal orientation <110>*2 (%) | Evaluation result | | | | | |
|---|---|---|---|---|---|---|---|---|---|---|---|---|---|---|---|
| | Si (% by mass) | Ni (mass ppm) | Pd (mass ppm) | Pt (mass ppm) | Ni+Pd+Pt (mass ppm) | | | | | Temperature cycle reliability | Rapid temperature cycle reliability | 1 st bondability | Bonding strength stability of 2nd bonding part | Loop straightness | Corrosion resistance in high-temperature and high-humidity environment |
| 44 | 5.0 | 149 | | | 149 | 4.0 | 2.9 | 30 | 41 | 3 | 2 | 2 | 2 | 2 | 2 |
| 45 | 5.0 | 10 | 3 | | 13 | 5.5 | 3.3 | 41 | 76 | 2 | 1 | 2 | 2 | 2 | 2 |
| 46 | 5.0 | 97 | 51 | | 148 | 4.0 | 2.8 | 31 | 35 | 3 | 3 | 2 | 2 | 2 | 2 |
| 47 | 5.1 | | | 3 | 3 | 5.5 | 3.4 | 44 | 80 | 2 | 1 | 2 | 2 | 2 | 2 |
| 48 | 5.0 | | 104 | 44 | 148 | 3.0 | 2.7 | 19 | 72 | 3 | 3 | 2 | 2 | 2 | 2 |

*1 Inspection surface is L cross-section (cross section in wire center axis direction including wire center axis)

*2 As a result of measuring crystal orientation of Si phase in L cross-section, among crystal orientations in wire center axis direction, orientation ratio (%) of crystal orientation <110> angled at 15° or less to wire center axis direction

[Table 3]

[Table 3]

(Table 3)

| | No. | Contained element and content concentration | | | | | Average diameter of Si phase*1 (μm) | Shape of Si phase*1 (a/b) | Average diameter of α phase*1 (μm) | Orientation ratio of crystal orientation <110>*2 (%) | Evaluation result | | | | | |
| | | Si (% by mass) | Ni (mass ppm) | Pd (mass ppm) | Pt (mass ppm) | Ni+Pd+Pt (mass ppm) | | | | | Temperature cycle reliability | Rapid temperature cycle reliability | 1 st bondability | Bonding strength stability of 2nd bonding part | Loop straightness | Corrosion resistance in high-temperature and high-humidity environment |
|---|---|---|---|---|---|---|---|---|---|---|---|---|---|---|---|---|
| Example | 49 | 7.0 | | | | 0 | 0.8 | 1.2 | 3 | 8 | 2 | 1 | 2 | 1 | 1 | 1 |
| | 50 | 7.1 | | | | 0 | 1.6 | 1.3 | 3 | 9 | 3 | 2 | 1 | 1 | 1 | 1 |
| | 51 | 7.0 | | | | 0 | 3.9 | 3.1 | 4 | 8 | 3 | 2 | 2 | 1 | 1 | 1 |
| | 52 | 7.0 | | | | 0 | 5.4 | 3.4 | 4 | 11 | 2 | 1 | 2 | 1 | 1 | 1 |
| | 53 | 7.2 | | | | 0 | 0.9 | 1.2 | 4 | 7 | 2 | 1 | 1 | 1 | 1 | 1 |
| | 54 | 7.0 | | | | 0 | 1.5 | 1.4 | 4 | 7 | 3 | 3 | 2 | 1 | 1 | 1 |
| | 55 | 7.0 | | | | 0 | 4.0 | 3.2 | 4 | 21 | 3 | 2 | 2 | 1 | 1 | 1 |
| | 56 | 7.0 | | | | 0 | 5.5 | 3.5 | 4 | 16 | 2 | 1 | 2 | 1 | 1 | 1 |
| | 57 | 7.1 | | | | 0 | 0.9 | 1.2 | 5 | 15 | 2 | 1 | 1 | 2 | 1 | 1 |
| | 58 | 7.0 | | | | 0 | 1.5 | 1.3 | 17 | 26 | 3 | 2 | 2 | 2 | 1 | 1 |
| | 59 | 7.0 | | | | 0 | 3.8 | 2.8 | 33 | 22 | 3 | 3 | 2 | 2 | 1 | 1 |
| | 60 | 7.0 | | | | 0 | 5.4 | 3.2 | 50 | 29 | 2 | 2 | 2 | 2 | 1 | 1 |
| | 61 | 7.1 | | | | 0 | 0.9 | 1.2 | 34 | 30 | 2 | 1 | 1 | 2 | 2 | 1 |
| | 62 | 7.0 | | | | 0 | 1.7 | 1.4 | 22 | 55 | 3 | 3 | 2 | 2 | 2 | 1 |
| | 63 | 7.0 | | | | 0 | 4.0 | 3.1 | 33 | 80 | 3 | 2 | 2 | 2 | 2 | 1 |
| | 64 | 7.0 | | | | 0 | 5.5 | 3.2 | 45 | 76 | 2 | 2 | 2 | 2 | 2 | 1 |

*1 Inspection surface is L cross-section (cross section in wire center axis direction including wire center axis)

*2 As a result of measuring crystal orientation of Si phase in L cross-section, among crystal orientations in wire center axis direction, orientation ratio (%) of crystal orientation <110> angled at 15° or less to wire center axis direction

EP 4 534 709 A1

[Table 4]

[Table 4]

(Table 4)

| | No. | Contained element and content concentration | | | | | Average diameter of Si phase*1 (μm) | Shape of Si phase*1 (a/b) | Average diameter of α phase*1 (μm) | Orientation ratio of crystal orientation <110>*2 (%) | Evaluation result | | | | | |
|---|---|---|---|---|---|---|---|---|---|---|---|---|---|---|---|---|
| | | Si (% by mass) | Ni (mass ppm) | Pd (mass ppm) | Pt (mass ppm) | Ni+Pd+Pt (mass ppm) | | | | | Temperature cycle reliability | Rapid temperature cycle reliability | 1 st bondability | Bonding strength stability of 2nd bonding part | Loop straightness | Corrosion resistance in high-temperature and high-humidity environment |
| Example | 65 | 10.0 | | | | 0 | 0.8 | 1.2 | 3 | 7 | 2 | 1 | 1 | 1 | 1 | 1 |
| | 66 | 10.0 | | | | 0 | 1.7 | 1.3 | 4 | 7 | 3 | 2 | 1 | 1 | 1 | 1 |
| | 67 | 10.0 | | | | 0 | 4.0 | 3.0 | 4 | 5 | 3 | 2 | 1 | 1 | 1 | 1 |
| | 68 | 10.0 | | | | 0 | 5.5 | 3.2 | 4 | 7 | 2 | 2 | 1 | 1 | 1 | 1 |
| | 69 | 10.0 | | | | 0 | 0.9 | 1.3 | 4 | 9 | 2 | 2 | 1 | 1 | 1 | 1 |
| | 70 | 10.0 | | | | 0 | 1.5 | 1.4 | 4 | 8 | 3 | 3 | 1 | 1 | 1 | 1 |
| | 71 | 10.0 | | | | 0 | 3.9 | 1.9 | 4 | 21 | 3 | 3 | 1 | 1 | 1 | 1 |
| | 72 | 10.0 | | | | 0 | 5.4 | 3.0 | 4 | 16 | 2 | 2 | 1 | 1 | 1 | 1 |
| | 73 | 10.0 | | | | 0 | 0.8 | 1.2 | 5 | 14 | 2 | 1 | 1 | 2 | 1 | 1 |
| | 74 | 10.0 | | | | 0 | 1.6 | 1.5 | 16 | 23 | 3 | 3 | 1 | 2 | 1 | 1 |
| | 75 | 10.0 | | | | 0 | 4.0 | 3.1 | 32 | 22 | 3 | 2 | 1 | 2 | 1 | 1 |
| | 76 | 10.0 | | | | 0 | 5.5 | 3.2 | 50 | 28 | 2 | 2 | 1 | 2 | 1 | 1 |
| | 77 | 10.0 | | | | 0 | 0.8 | 1.2 | 35 | 30 | 2 | 1 | 1 | 2 | 2 | 1 |
| | 78 | 10.0 | | | | 0 | 1.5 | 1.4 | 22 | 54 | 3 | 3 | 1 | 2 | 2 | 1 |
| | 79 | 10.0 | | | | 0 | 3.9 | 1.7 | 23 | 75 | 3 | 3 | 1 | 2 | 2 | 1 |
| | 80 | 10.0 | | | | 0 | 5.4 | 2.9 | 34 | 80 | 2 | 2 | 1 | 2 | 2 | 1 |

*1 Inspection surface is L cross-section (cross section in wire center axis direction including wire center axis)

*2 As a result of measuring crystal orientation of Si phase in L cross-section, among crystal orientations in wire center axis direction, orientation ratio (%) of crystal orientation <110> angled at 15° or less to wire center axis direction

[Table 5]

[Table 5]

(Table 5)

| | No. | Si (% by mass) | Ni (mass ppm) | Pd (mass ppm) | Pt (mass ppm) | Ni+Pd+Pt (mass ppm) | Average diameter of Si phase *1 (μm) | Shape of Si phase *1 (a/b) | Average diameter of α phase *1 (μm) | Orientation ratio of crystal orientation <110> *2 (%) | Temperature cycle reliability | Rapid temperature cycle reliability | 1 st bondability | Bonding strength stability of 2nd bonding part | Loop straightness | Corrosion resistance in high-temperature and high-humidity environment |
|---|---|---|---|---|---|---|---|---|---|---|---|---|---|---|---|---|
| | | | | | | | | | | | Evaluation result | | | | | |
| Comparative Example | 1 | 2.9 | | | | 0 | 1.2 | 1.2 | 18 | 6 | 0 | 0 | 2 | 1 | 1 | 1 |
| | 2 | 10.1 | | | | 0 | 1.0 | 1.2 | 13 | 11 | 2 | 1 | 0 | 1 | 1 | 1 |
| | 3 | 3.0 | | | | 0 | 0.7 | 1.3 | 19 | 25 | 0 | 0 | 2 | 1 | 1 | 1 |
| | 4 | 10.0 | | | | 0 | 0.7 | 1.2 | 13 | 16 | 2 | 1 | 0 | 1 | 1 | 1 |
| | 5 | 3.0 | | | | 0 | 5.6 | 3.3 | 20 | 14 | 1 | 0 | 0 | 1 | 1 | 1 |
| | 6 | 10.0 | | | | 0 | 5.6 | 3.3 | 11 | 15 | 2 | 1 | 0 | 1 | 1 | 1 |

*1 Inspection surface is L cross-section (cross section in wire center axis direction including wire center axis)

*2 As a result of measuring crystal orientation of Si phase in L cross-section, among crystal orientations in wire center axis direction, orientation ratio (%) of crystal orientation <110> angled at 15° or less to wire center axis direction

It was confirmed that all bonding wires in Examples Nos. 1 to 80 contained 3.0% by mass or more and 10.0% by mass or less of Si, had the average diameter of the Si phase in the L cross-section equal to or larger than 0.8 μm and equal to or smaller than 5.5 μm, and had excellent temperature cycle reliability and a favorable 1st bondability.

Additionally, it was confirmed that the bonding wires in Examples Nos. 2, 3, 5 to 8, 10, 11, 13 to 22, 24, 25, 27 to 30, 32 to 38, 40 to 42, 44, 46, 48, 50, 51, 54, 55, 58 to 60, 62 to 64, 66 to 72, 74 to 76, and 78 to 80 brought a more favorable result for the rapid temperature cycle reliability, in which the average value of the ratio (a/b) between the length (a) of the Si phase in the wire center axis direction in the L cross-section and the length (b) of the Si phase in the direction perpendicular to the wire center axis in the L cross-section was equal to or larger than 1.3 and equal to or smaller than 3.2.

It was also confirmed that the bonding wires in Examples Nos. 9 to 22, 31 to 48, 57 to 64, and 73 to 80 brought a more favorable result for the bonding strength stability of the 2nd bonding part, in which the average diameter of the α phase in the L cross-section was equal to or larger than 5 μm and equal to or smaller than 50 μm.

As a result of measuring the crystal orientation of the Si phase in the L cross-section, it was confirmed that the bonding wires in Examples Nos. 35 to 48, 61 to 64, and 77 to 80 brought a more favorable result for the loop straightness, in which the orientation ratio of the crystal orientation <110> was equal to or higher than 30% and equal to or lower than 80%.

Furthermore, it was confirmed that the bonding wires in Examples Nos. 17 to 22, and 43 to 48 brought a more favorable result for the corrosion resistance in a high-temperature and high-humidity environment, the bonding wires containing 3 mass ppm or more and 150 mass ppm or less of one or more of Ni, Pd, and Pt in total.

On the other hand, it was confirmed that, in the bonding wires in Comparative Examples Nos. 1 to 6, at least one of the Si concentration and the average diameter of the Si phase in the L cross-section was out of the range of the present invention, and any of the temperature cycle reliability and the 1st bondability was not sufficiently obtained.

## Claims

1. An Al alloy bonding wire containing 3.0% by mass or more and 10.0% by mass or less of Si, wherein an average diameter of a Si phase in a cross section in a wire center axis direction including a wire center axis of the Al alloy bonding wire (L cross-section) is equal to or larger than 0.8 μm and equal to or smaller than 5.5 μm.

2. The Al alloy bonding wire according to claim 1, wherein an average value of a ratio (a/b) between a length (a) of the Si phase in the wire center axis direction in the L cross-section and a length (b) of the Si phase in a direction perpendicular to the wire center axis in the L cross-section is equal to or larger than 1.3 and equal to or smaller than 3.2.

3. The Al alloy bonding wire according to claim 1 or 2, wherein an average diameter of an α phase in the L cross-section is equal to or larger than 5 μm and equal to or smaller than 50 μm.

4. The Al alloy bonding wire according to any one of claims 1 to 3, wherein, as a result of measuring a crystal orientation of the Si phase in the L cross-section, among crystal orientations in the wire center axis direction, an orientation ratio of a crystal orientation <110> angled at 15° or less to the wire center axis direction is equal to or higher than 30% and equal to or lower than 80%.

5. The Al alloy bonding wire according to any one of claims 1 to 4, further containing 3 mass ppm or more and 150 mass ppm or less of one or more of Ni, Pd, and Pt in total.

6. The Al alloy bonding wire according to any one of claims 1 to 5, wherein a balance of the Al alloy bonding wire comprises Al and inevitable impurities.

7. A semiconductor device comprising the Al alloy bonding wire according to any one of claims 1 to 6.

[Figure 1]

L CROSS-SECTION
(CROSS SECTION IN
WIRE CENTER AXIS
DIRECTION INCLUDING
WIRE CENTER AXIS)

WIRE CENTER AXIS

[Figure 2]

$a$

$b$

Si
PHASE

WIRE CENTER
AXIS DIRECTION

## INTERNATIONAL SEARCH REPORT

| International application No. |
| --- |
| **PCT/JP2023/024324** |

**A. CLASSIFICATION OF SUBJECT MATTER**

*C22C 21/02*(2006.01)i; *C22F 1/00*(2006.01)i; *C22F 1/043*(2006.01)i; *H01L 21/60*(2006.01)i
FI:  C22C21/02; C22F1/043; C22F1/00 605; C22F1/00 614; C22F1/00 625; C22F1/00 630G; C22F1/00 650A; C22F1/00
661Z; C22F1/00 681; C22F1/00 682; C22F1/00 685Z; C22F1/00 686A; C22F1/00 691B; C22F1/00 691C; C22F1/00
691Z; C22F1/00 694A; C22F1/00 694Z; H01L21/60 301F

According to International Patent Classification (IPC) or to both national classification and IPC

**B. FIELDS SEARCHED**

Minimum documentation searched (classification system followed by classification symbols)
C22C21/02; C22F1/00; C22F1/043; H01L21/60

Documentation searched other than minimum documentation to the extent that such documents are included in the fields searched
Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | CN 110656263 A (INSTITUTE OF METAL RESEARCH, CHINESE ACADEMY OF SCIENCES) 07 January 2020 (2020-01-07) paragraphs [0020]-[0024], fig. 2, 3 | 1, 7 |
| A | entire text, all drawings | 2-6 |
| A | JP 3-32033 A (HITACHI, LTD.) 12 February 1991 (1991-02-12) entire text, all drawings | 1–7 |
| A | JP 2013-140986 A (NIPPON STEEL SUMIKIN MATERIALS CO., LTD.) 18 July 2013 (2013-07-18) entire text, all drawings | 1–7 |
| A | JP 59-67642 A (HITACHI, LTD.) 17 April 1984 (1984-04-17) entire text, all drawings | 1–7 |
| A | JP 2006-80518 A (EUPEC GMBH & CO KG) 23 March 2006 (2006-03-23) entire text, all drawings | 1–7 |

☑ Further documents are listed in the continuation of Box C.    ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **04 September 2023** | **19 September 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

International application No.

**PCT/JP2023/024324**

### C. DOCUMENTS CONSIDERED TO BE RELEVANT

| Category* | Citation of document, with indication, where appropriate, of the relevant passages | Relevant to claim No. |
|---|---|---|
| A | JP 2003-27171 A (SUMITOMO ELECTRIC INDUSTRIES, LTD.) 29 January 2003 (2003-01-29)<br>entire text, all drawings | 1-7 |

Form PCT/ISA/210 (second sheet) (January 2015)

**INTERNATIONAL SEARCH REPORT**
Information on patent family members

International application No.

**PCT/JP2023/024324**

| Patent document cited in search report | | | Publication date (day/month/year) | Patent family member(s) | | | Publication date (day/month/year) |
|---|---|---|---|---|---|---|---|
| CN | 110656263 | A | 07 January 2020 | (Family: none) | | | |
| JP | 3-32033 | A | 12 February 1991 | (Family: none) | | | |
| JP | 2013-140986 | A | 18 July 2013 | US entire text, all drawings WO KR | 2004/0014266 2002/023618 10-2006-0041322 | A1 A1 A | |
| JP | 59-67642 | A | 17 April 1984 | (Family: none) | | | |
| JP | 2006-80518 | A | 23 March 2006 | US entire text, all drawings DE | 2006/0055041 102004043020 | A1 B3 | |
| JP | 2003-27171 | A | 29 January 2003 | US entire text, all drawings DE | 2003/0026726 10232159 | A1 A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014131010 A
- JP 2014129578 A
- JP S59057440 A
- JP 2020150116 A